# EUROPÄISCHE PATENTSCHRIFT

(11) **EP 3 948 419 B1**
(45) Veröffentlichungstag und Bekanntmachung des Hinweises auf die Patenterteilung: **14.12.2022**
(21) Anmeldenummer: 20715837.9
(22) Anmeldetag: 30.03.2020
(51) Int. Cl.: G03F 7/12, H01L 21/67, B41F 9/00, B41M 1/10, H01L 31/18, B41J 2/14

(54) **VORRICHTUNG UND VERFAHREN ZUM AUFBRINGEN EINER STRUKTUR AUS DRUCKMEDIUM AUF EIN SUBSTRAT**
DEVICE AND METHOD FOR APPLYING A STRUCTURE MADE OF A PRINTING MEDIUM TO A SUBSTRATE
DISPOSITIF ET PROCÉDÉ D'APPLICATION, SUR UN SUBSTRAT, D'UNE STRUCTURE EN MOYEN D'IMPRESSION

(30) Priorität: 03.04.2019 DE 102019108763
(43) Veröffentlichungstag der Anmeldung: 09.02.2022
(73) Patentinhaber: Fraunhofer-Gesellschaft zur Förderung der angewandten Forschung e.V., 80686 München (DE)
(72) Erfinder: LORENZ, Andreas, 79110 Freiburg (DE); POSPISCHIL, Maximilian, 79110 Freiburg (DE); TEPNER, Sebastian, 79110 Freiburg (DE); CLEMENT, Florian, 79110 Freiburg (DE); KUCHLER, Martin, 79110 Freiburg (DE)
(74) Vertreter: LBP Lemcke, Brommer & Partner Patentanwälte mbB
(86) Internationale Anmeldenummer: PCT/EP2020/058890
(87) Internationale Veröffentlichungsnummer: WO 2020/201177

(56) Entgegenhaltungen:
- WO-A1-2015/071270
- DE-A1-102005 002 837
- DE-A1-102010 026 734

## Beschreibung

Die Erfindung betrifft eine Vorrichtung und ein Verfahren zum Aufbringen einer Struktur aus Druckmedium auf ein Substrat nach den Oberbegriffen der Ansprüche 1 und 10.

Zum Aufbringen einer Struktur aus Druckmedium auf ein Substrat sind Rotationsdruckverfahren bekannt. Bei solchen Verfahren wird mittels einer Druckmedium-Zuführeinheit Druckmedium zu einem Transferzylinder zugeführt und das Druckmedium von dem Transferzylinder mittelbar oder unmittelbar auf ein Substrat übertragen, um die Struktur aus Druckmedium auf dem Substrat auszubilden. Zum Ausbilden der Struktur werden hierbei strukturierte Bereiche auf einer Druckform, beispielsweise erhöhte Bereiche im Hochdruck- oder Flexodruckverfahren, vertiefte Bereiche im Tiefdruckverfahren oder geöffnete Bereiche eines Gewebes im Durchdruck- oder Siebdruckverfahren mit hoher Reproduzierbarkeit präzise auf eine vorbestimmte Position auf dem Substrat übertragen.

Dokument DE 10 2010 026734 A1 beschreibt eine Vorrichtung und ein Druckverfahren mit einem rotierenden Zylinder, der Vertiefungen aufweist, wobei ein Druckmedium in die Vertiefungen eindringt.

Der vorliegenden Erfindung liegt die Aufgabe zugrunde, den Einsatzbereich der vorbekannten Rotationsdruckverfahren zu erweitern.

Gelöst ist diese Aufgabe durch eine Vorrichtung zum Aufbringen einer Struktur aus Druckmedium auf dem Substrat gemäß Anspruch 1 sowie durch ein Verfahren zum Aufbringen einer Struktur aus Druckmedium auf ein Substrat gemäß Anspruch 10. Vorteilhafte Ausgestaltungen finden sich in den abhängigen Ansprüchen.

Die erfindungsgemäße Vorrichtung ist bevorzugt zur Durchführung des erfindungsgemäßen Verfahrens, insbesondere einer bevorzugten Ausführungsform hiervon, ausgebildet. Das erfindungsgemäße Verfahren ist bevorzugt zur Durchführung mittels der erfindungsgemäßen Vorrichtung, insbesondere einer bevorzugten Ausführungsform hiervon, ausgebildet.

Der vorliegenden Erfindung liegt die Erkenntnis zugrunde, dass ein Bedarf an Druckverfahren besteht, welche Strukturen aus Druckmedium auf ein Substrat aufbringen, welche eine Mehrzahl parallel voneinander beabstandeter Linien aufweisen. Solche Linien- und/oder Gitterstrukturen sind für eine Vielzahl von Funktionalitäten wünschenswert, beispielsweise zur Herstellung von Leiterbahnen für elektrischen Strom auf einem Substrat, Bahnen aus Druckmedium mit Dotierstoffen, um in einem Substrat, insbesondere einem Halbleitersubstrat, linienartige Dotierbereiche auszubilden, das Ausbilden von Isolationsstrukturen oder Barrierestrukturen oder das Ausbilden von Lichtleitern.

Insbesondere das Aufbringen von Druckmedium auf Halbleitersubstrate oder Substrate, welche mit Halbleiterschichten beschichtet sind, ist bei der Herstellung von elektronischen Bauelementen und insbesondere bei der Herstellung von photovoltaischen Solarzellen von großem Interesse. Hier sind insbesondere zur Kostenreduzierung eine hohe Druckgeschwindigkeit und somit ein hoher Durchsatz wünschenswert.

Es ist bekannt, mittels Dispenseinheiten parallele Linien von Druckmedium auf ein Substrat auszugeben. Hierbei können mehrere Dispenseinheiten parallel nebeneinander angeordnet sein oder eine Dispenseinheit eine Düse mit einer Mehrzahl nebeneinander angeordneten Öffnungen aufweisen, sodass gleichzeitig eine Mehrzahl von Druckmediumlinien mittels einer Dispenseinheit ausgegeben werden kann. Bisher wurde davon ausgegangen, dass die unmittelbare Ausgabe von Druckmedium aus der Dispenseinheit auf das Substrat die schnellste und kostengünstigste Lösung darstellt.

Untersuchungen der Anmelderin zeigen jedoch, dass insbesondere bei Beginn und Ende des Druckverfahrens, d. h. am Anfangspunkt einer Linie aus Druckmedium sowie am Endpunkt einer solchen Druckmediumlinie technisch große Herausforderungen bestehen, um insbesondere bei Hochgeschwindigkeits-Dispensionsprozessen den Anfangs- und Endpunkt der Druckmediumlinie exakt zu definieren. Insbesondere stellt es eine hohe technische Herausforderung dar, bei Ausgabe einer Mehrzahl paralleler Linien diese mit exakt gleicher Länge und auf einer gemeinsamen Linie liegenden Anfangspunkten sowie auf einer hierzu parallelen gemeinsamen Linie liegenden Endpunkten auszugeben.

Die vorliegende Erfindung sieht daher eine Kombination von Rotationsdruck und Dispensdruck vor:
Die erfindungsgemäße Vorrichtung zum Aufbringen einer Struktur aus Druckmedium auf ein Substrat weist einen drehbaren Transferzylinder, eine Druckmedium-Zuführeinheit und eine Substrat-Zuführeinheit auf. Die Druckmedium-Zuführeinheit ist ausgebildet, Druckmedium zu dem Transferzylinder zuzuführen. Die Vorrichtung ist ausgebildet, Druckmedium mittelbar oder unmittelbar von dem Transferzylinder auf das mittels der Substrat-Zuführeinheit zugeführte Substrat zu übertragen, um die Struktur aus Druckmedium auf dem Substrat auszubilden.

Wesentlich ist, dass die Druckmedium-Zuführeinheit eine Dispenseinheit mit einer Mehrzahl von Ausgabeöffnungen für Druckmedium aufweist, wobei die Dispenseinheit mit dem als Dispens-Transferzylinder ausgebildeten Transferzylinder zusammenwirkend ausgebildet ist, um gleichzeitig eine Mehrzahl parallel und voneinander beabstandeter Druckmediumlinien von Druckmedium auf den Dispens-Transferzylinder aufzubringen. Weiterhin weist die Vorrichtung zumindest eine Längenbegrenzungseinheit auf, welche ausgebildet ist, die Länge der mittels der Dispenseinheit erzeugten Druckmediumlinien auf den Dispens-Transferzylinder und/oder einem weiteren Transferzylinder der Vorrichtung zu begrenzen.

Die vorliegende Erfindung ist in der Erkenntnis der Anmelderin begründet, dass grundsätzlich das Verwenden einer Dispenseinheit mit einer Mehrzahl von Ausgabeöffnungen zum Erzeugen einer Mehrzahl paralleler, voneinander beabstandeter Linien aus Druckmedium vorteilhaft ist. Das Problem von Ungenauigkeiten hinsichtlich der Anfangs- und Endpunkte der Druckmediumlinien (auch "Start-Stopp-Problematik" genannt) wird erfindungsgemäß gelöst, indem die Druckmediumlinien mittels der Dispenseinheit lediglich mittelbar, über zumindest den Dispens-Transferzylinder auf das Substrat übertragen werden und eine Längenbegrenzungseinheit für eine Längenbegrenzung der Druckmediumlinien auf dem Dispens-Transferzylinder und/oder einem weiteren Transferzylinder verwendet wird.

Hierdurch werden die hohe Druckgeschwindigkeit und der hohe Durchsatz, welcher mit Dispenseinheiten erzielt werden kann, nicht verringert, da auch das Rotationsdruckverfahren an sich für hohe Druckgeschwindigkeiten geeignet ist. Insbesondere ist es jedoch nicht notwendig, eine exakte Länge der Druckmediumlinien dadurch zu erzielen, dass die Ausgabe von Druckmedium aus der Dispenseinheit mit hoher Genauigkeit gestartet und gestoppt wird. Durch das zusätzliche Vorsehen der Längenbegrenzungseinheit wird somit mit einer zusätzlichen Einheit die Start-Stopp-Problematik gelöst oder zumindest hieraus resultierende Längenungenauigkeiten erheblich verringert.

Das erfindungsgemäße Verfahren zum Aufbringen einer Struktur aus Druckmedium auf ein Substrat weist folgende Verfahrensschritte auf:
A. Aufbringen von Druckmedium auf einen drehbaren Transferzylinder und
B. Mittelbares oder unmittelbares Übertragen des Druckmediums von dem Transferzylinder auf das Substrat (9),

Wesentlich ist, dass im Verfahrensschritt A das Druckmedium mittels Dispensen in einer Mehrzahl paralleler und voneinander beabstandeter Druckmediumlinien auf den als Dispens-Transferzylinder ausgebildeten Transferzylinder aufgebracht wird und dass mittels einer Längenbegrenzungseinheit die Länge der Druckmediumlinien auf dem Dispens-Transferzylinder und/oder einem weiteren Transferzylinder vor Durchführen von Verfahrensschritt B begrenzt wird.

Hierdurch ergeben sich die zuvor genannten Vorteile.

Vorteilhafterweise weist die Längenbegrenzungseinheit zumindest ein Begrenzungselement auf, welches auf der Mantelfläche des Dispens-Transferzylinders oder eines weiteren Transferzylinders angeordnet ist, um die Länge der Druckmediumlinien zu begrenzen.

Ein solches Begrenzungselement kann als Steg ausgebildet sein, insbesondere ein parallel zu einer Drehachse des Transferzylinders angeordneter Steg. Ebenso liegt es im Rahmen der Erfindung, dass nach dem Prinzip des Hochdrucks oder nach dem Prinzip des Tiefdrucks Strukturen auf den Transferzylinder vorgesehen sind, welche das Begrenzungselement aufweisen. Insbesondere kann ein Rand einer Hochdruckform oder einer Tiefdruckform als Begrenzungselement dienen. Besonders vorteilhaft ist es, dass die Längenbegrenzungseinheit zumindest einem Begrenzungselement aufweist, welches auf der Mantelfläche des Dispens-Transferzylinders oder eines weiteren Transferzylinders angeordnet ist.

Hierdurch wird in einfacher Weise eine Längenbegrenzung erzielt.

Vorteilhafterweise weist die Längenbegrenzungseinheit zusätzlich zu dem Begrenzungselement ein Abstreifelement auf, welches mit dem Transferzylinder, auf welchem das Begrenzungselement angeordnet ist, zusammenwirkend ausgebildet ist, sodass überschüssiges Druckmedium, insbesondere Druckmedium, welches sich auf dem Begrenzungselement befindet, mittels des Abstreifelementes entfernt wird. Ein solches Abstreifelement ist bevorzugt als Rakel ausgebildet, welcher an dem Transferzylinder angeordnet ist, ohne jedoch dessen Drehbewegung auszuführen, sodass bei Drehen des Transferzylinders durch die Relativbewegung zwischen Rakel und Transferzylinder ein Abstreifen des überschüssigen Druckmediums erfolgt.

Vorteilhafterweise weist die Vorrichtung einen zweiten drehbaren Transferzylinder auf, welcher mit dem Dispens-Transferzylinder zusammenwirkend ausgebildet und angeordnet ist, um die Druckmediumlinien zumindest teilweise von dem Dispens-Transferzylinder aufzunehmen und auf das Substrat zu übertragen. Hierdurch ergibt sich der Vorteil, dass der zweite Transferzylinder eine für die Übertragung auf das Substrat optimierte Oberfläche aufweisen kann (z.B. flexible, elastische Oberfläche für den Druck auf harte, unebene Substrate) während der erste Transferzylinder für die Längenbegrenzung des dispensierten Druckmediums optimiert ist. Vorteilhafterweise weist der zweite Transferzylinder daher eine zu dem ersten Transferzylinder unterschiedliche Oberflächenbeschaffenheit auf. Insbesondere weist der zweite Transferzylinder bevorzugt eine weichere Mantelfläche verglichen mit der Mantelfläche des ersten Transferzylinders auf.

Insbesondere ist es vorteilhaft, die Längenbegrenzungseinheit mit dem Dispens-Transferzylinder zusammenwirkend auszugestalten und anzuordnen, sodass die Druckmediumlinien in durch die Längenbegrenzungseinheit begrenzter Länge auf den zweiten Transferzylinder übertragen werden.

Hierdurch ergibt sich der Vorteil, dass die Oberflächeneigenschaften beider Zylinder für eine exakte Längenbegrenzung bei der Übertragung zwischen beiden Zylindern optimiert werden können.

Ebenso liegt es im Rahmen der Erfindung, dass die Druckmediumlinien von dem Dispens-Transferzylinder auf den zweiten Transferzylinder übertragen werden und bevorzugt von dem zweiten Transferzylinder auf das Substrat übertragen werden. Insbesondere ist es vorteilhaft, dass die Längenbegrenzung der Druckmediumlinien an und/oder auf dem zweiten Transferzylinder erfolgt, insbesondere mittels der Längenbegrenzungseinheit. Hierdurch ergibt sich der Vorteil, dass die Oberflächeneigenschaften des zweiten Zylinders für die Übertragung des Druckmediums auf das Substrat individuell optimiert werden kann.

Der Dispens-Transferzylinder wird bevorzugt um eine Drehachse gedreht, insbesondere mittels eines motorischen Mittels gedreht. Die Mehrzahl der Ausgabeöffnungen für Druckmedium der Dispenseinheit sind bevorzugt entlang einer Linie angeordnet. Die Drehachse des Transferzylinders ist bevorzugt parallel zu dieser Linie angeordnet.

In bevorzugten Ausführungsformen, in welchen die Vorrichtung mehrere Transferzylinder aufweist, sind die Drehachsen der Transferzylinder bevorzugt parallel zu der Drehachse des Dispens-Transferzylinders angeordnet.

Ebenso erfolgt bevorzugt ein Drehen aller Transferzylinder mittels motorischer Mittel. Die Drehrichtung benachbarter Transferzylinder ist bevorzugt gegenläufig.

Vorteilhafterweise weist die Längenbegrenzungseinheit eine Hochdruckform auf, welche auf der Mantelfläche des Dispens-Transferzylinders oder eines weiteren Transferzylinders angeordnet ist, um die Länge der Druckmediumlinien zu begrenzen. Insbesondere ist es vorteilhaft, dass die Hochdruckform auf der Mantelfläche eines zweiten Transferzylinders angeordnet ist. Hierdurch ergibt sich der Vorteil, dass die Hochdruckform lediglich die zu übertragenden Bereiche des dispensierten Druckmediums vom ersten Transferzylinder übernimmt, während die nicht zu übertragenden Bereiche auf dem ersten Transferzylinder verbleiben und dort mittels einer Reinigungsvorrichtung abgenommen und ggf. zurückgeführt werden können.

In einer weiteren vorteilhaften Ausführungsform weist die Längenbegrenzungseinheit eine selektive Druckmedium-Aufnahmefläche auf, welche auf der Mantelfläche des Dispens-Transferzylinders oder eines weiteren Transferzylinders angeordnet ist, um die Länge der Druckmediumlinien zu begrenzen. Die selektive Druckmedium-Aufnahmefläche weist zumindest einen Aufnahmebereich mit höherer Haftung für das Druckmedium und zumindest einen Sperrbereich mit gegenüber dem Aufnahmebereich geringerer Haftung für das Druckmedium auf, um mittels des Sperrbereichs die Länge der Druckmediumlinien im Aufnahmebereich zu begrenzen. Zusätzlich oder alternativ weist die Druckmedium-Aufnahmefläche bevorzugt einen Aufnahmebereich mit einer für das Druckmedium gut benetzbaren Oberfläche (Druckmedium-annehmende Oberfläche) und zumindest enien Sperrbereich mit gegenüber dem Aufnahmebereich schlecht oder gar nicht benetzbaren Oberfläche (Druckmedium-abweisende Oberfläche).

Hierdurch ergibt sich der Vorteil, dass der Abriss und damit die Längenbegrenzung der dispensierten Drucklinien am Übergang zwischen annehmender und abweisender Oberfläche sehr exakt und störungsfrei erfolgen kann.

In einer weiteren vorteilhaften Ausgestaltung der erfindungsgemäßen Vorrichtung weist die Längenbegrenzungseinheit eine Bewegungsrichtung für den Dispens-Transferzylinder auf, um den Dispens-Transferzylinder relativ zu einem oder mehreren der Elemente
- Dispenseinheit,
- Substrat,
- einem weiteren Transferzylinder, insbesondere dem zweiten Transferzylinder, wie zuvor beschrieben,
zu bewegen, sodass aufgrund der Relativbewegung, insbesondere einem Abheben des Dispens-Transferzylinders von dem Substrat, eine Unterbrechung der Druckmediumlinien erfolgt.

In einer vorteilhaften Weiterbildung erfolgt die vorgenannte Bewegung in Verbindung mit einer kurzzeitigen Änderung der Drehgeschwindigkeit (z.b. Beschleunigung) des Dispens-Transferzylinders oder eines weiteren Transferzylinders.

In diesem Fall erfolgt die Längenbegrenzung somit durch mechanisches Strecken der Druckmediumlinien aufgrund der vorgenannten Bewegung, sodass schließlich ein Abriss der Druckmediumlinien erfolgt. Der Dispens-Transferzylinder wird somit aus einer Aufnahmeposition nach Erreichen der vorgewünschten Länge der Druckmediumlinie von einem oder mehreren der vorgenannten Elemente mittels der Bewegungsvorrichtung entfernt, sodass ein Abriss der Druckmediumlinien erfolgt. Anschließend wird der Dispens-Transferzylinder mittels der Bewegungsrichtung wieder dem Element, von dem er zuvor wegbewegt wurde, angenähert, um einen neuen Übertrag von Druckmediumlinien zu ermöglichen.

Hierdurch ergibt sich der Vorteil, dass die Relativbewegung des Zylinders maschinenbauseitig exakt und reproduzierbar steuerbar ist, bevorzugt erfolgt die Steuerung der Relativbewegung über Kurvenscheiben und damit eine hohe Reproduzierbarkeit der Längenbegrenzung erreicht wird. Gleichzeitig wird der kontinuierliche Dispensierprozess nicht beeinflusst, was bei einem Abheben der Dispenseinheit der Fall wäre und zu Störungen im Dispensierprozess führen kann.

In einer weiteren vorteilhaften Ausgestaltung weist die Längenbegrenzungseinheit eine Trennvorrichtung mit zumindest einem Trennelement auf, welches mit dem Dispens-Transferzylinder und/oder einem weiteren Transferzylinder zusammenwirkend ausgebildet ist, um mittels des Trennelementes eine Unterbrechung der Druckmediumlinien auf den Dispens-Transferzylinder und/oder einen weiteren Transferzylinder zu erzeugen. In dieser vorteilhaften Ausführungsform erfolgt somit eine mechanische Unterbrechung der Druckmediumlinien mittels des Trennelementes.

Das Trennelement ist bevorzugt als Trennrakel ausgebildet. Insbesondere ist der Trennrakel bevorzugt auf einem drehbaren Trennzylinder angeordnet. Der Trennzylinder weist bevorzugt eine Drehachse parallel zu der Drehachse desjenigen Transferzylinders auf, auf welchem die Längenbegrenzung der Druckmediumlinien mittels des Trennrakels erfolgen soll. Insbesondere ist der Trennzylinder bevorzugt gegenläufig zur Drehrichtung des zugeordneten Transferzylinders angetrieben.

Vorteilhafterweise erfolgt die Längenbegrenzung bei dem erfindungsgemäßen Verfahren mittels eines oder mehrerer der Verfahrensschritte aus der Liste
- Verwenden zumindest eines Begrenzungselementes, welches auf der Mantelfläche des Dispens-Transferzylinders oder eines weiteren Transferzylinders angeordnet ist,
- Verwenden einer Hochdruckform mit zumindest einem Begrenzungselement, welches auf der Mantelfläche des Dispens-Transferzylinders oder eines weiteren Transferzylinders angeordnet ist,
   erfolgt,
- Verwenden einer Hochdruckform, welche auf der Mantelfläche des Dispens-Transferzylinders oder eines weiteren Transferzylinders angeordnet ist,
- Verwenden einer selektiven Druckmediumaufnahmefläche, welche auf der Mantelfläche des Dispens-Transferzylinders oder eines weiteren Transferzylinders angeordnet ist, wobei die selektive Druckmedium-aufnahmefläche zumindest einen Aufnahmebreich mit höherer Haftung für das Druckmedium und/oder einer für das Druckmedium besser benetzbaren Oberfläche
   und zumindest einen Sperrbereich mit gegenüber dem Aufnahmebereich geringerer Haftung für das Druckmedium und/oder einer für das Druckmedium geringer oder nicht benetzbaren Oberfläche aufweist, so dass mittels des Sperrbereichs die Länge der Druckmediumlinien im Aufnahmebereich begrenzt werden,
- Bewegen des Dispens-Transferzylinders relativ zu einem oder mehreren der Elemente
   - Dispenseinheit,
   - Substrat,
   - einem weiteren Transferzylinder, insbesondere dem zweiten Transferzylinder,
so dass aufgrund der Relativbewegung die Druckmediumlinien unterbrochen werden.

Für einige Anwendungen, insbesondere zum Erzeugen von Strukturen für Halbleiterbauelemente, ist es vorteilhaft, dass in einer bevorzugten Ausgestaltung der erfindungsgemäßen Vorrichtung die Längenbegrenzungseinheit eine Querlinien-Ausgabeeinheit aufweist, welche ausgebildet ist, zusätzlich zu den parallelen Druckmedienlinien eine oder mehrere Querlinien aus Druckmedium auf den Dispens-Transferzylinder oder einen weiteren Transferzylinder aufzubringen, wobei die Querlinie nicht parallel zu den parallelen Druckmediumlinien ist. Insbesondere ist es vorteilhaft, dass die Querlinie mit den parallelen Druckmediumlinien einen Winkel im Bereich 0,5° bis 15° einschließt.

In einer weiteren vorteilhaften Ausführungsform des erfindungsgemäßen Verfahrens weist die Längenbegrenzungseinheit eine Druckmedium-Abführeinheit auf, um überschüssiges Druckmedium der Druckmediumlinien von dem Dispens-Transferzylinder und/oder einem weiteren Transferzylinder abzuführen. Bevorzugt erfolgt eine Rückführung des überschüssigen Druckmediums zu der Dispenseinheit, um den Verbrauch an Druckmedium zu verringern.

Vorteilhafterweise ist die Druckmedium-Abführeinheit in Drehrichtung des zugeordneten Transferzylinders einem Übergabebereich nachgeordnet, an welchem Übergabebereich die Druckmediumlinien auf einen weiteren Transferzylinder oder das Substrat übertragen werden. Auf diese Weise erfolgt somit zunächst ein Übertragen der Druckmediumlinien auf das Substrat oder einem nachgeordneten Transferzylinder und etwaiges verbleibendes Druckmedium wird anschließend mittels der Druckmedium-Abführeinheit entfernt.

In dieser vorteilhaften Ausführungsform ist somit keine Unterbrechung der Druckmedium-Ausgabe von der Dispenseinheit auf den Dispens-Transferzylinder notwendig, sodass ein kontinuierlicher Materialstrom von Druckmedium gewährleistet ist und nachteilige Effekte, insbesondere bei scherverdünnendem Druckmedium, vermieden werden.

Vorteilhafterweise werden die Druckmediumlinien auf eine Länge begrenzt, welche kleiner als die Länge des Substrats ist.

Vorteilhafterweise erfolgt bei dem erfindungsgemäßen Verfahren das Aufbringen von Druckmediumlinien auf eine Mehrzahl sequenziell zugeführter Substrate und währenddessen erfolgt ein kontinuierliches Dispensen von Druckmedium auf den Dispens-Transferzylinder.

Ebenso liegt die Verwendung von bahnförmigen Substraten im Bereich der Erfindung, insbesondere, dass auf ein bahnförmiges Substrat mehrfach hintereinander parallele Linien vordefinierter Länge gedruckt werden.

In einer vorteilhaften Ausführungsform des erfindungsgemäßen Verfahrens wird ein Druckmedium verwendet, welches Halbleiter-Dotierstoffe und/oder Metallpartikel enthält und als Substrat wird ein Halbleitersubstrat oder ein mit einer Halbleiterschicht beschichtetes Substrat verwendet, weiterhin wird mittels des Verfahrens eine Struktur zum Ausbilden einer metallischen Kontaktierungsstruktur und/oder einer Dotierstruktur zum Erzeugen selektiver Dotierbereiche in dem Halbleitersubstrat oder der Halbleiterschicht ausgebildet.

Das erfindungsgemäße Verfahren und die erfindungsgemäße Vorrichtung sind insbesondere zum Ausbilden von Strukturen aus Druckmedium auf Halbleitersubstraten oder Substraten mit einer Halbleiterschicht geeignet, insbesondere zur Herstellung großflächiger Halbleiterbauelemente wie beispielsweise photovoltaischer Solarzellen.

Die erfindungsgemäße Vorrichtung und das erfindungsgemäße Verfahren sind bevorzugt derart ausgebildet, dass auch nach Übertrag der Druckmediumlinien auf das Substrat die Druckmediumlinien als parallele, voneinander beabstandete Druckmediumlinien auf dem Substrat vorliegen.

Vorteilhafterweise wird mittels des erfindungsgemäßen Verfahrens eine Anzahl im Bereich von 5 - 200, insbesondere im Bereich von 10 - 100, parallele Druckmediumlinien erzeugt. Die Dispenseinheit weist somit bevorzugt eine entsprechende Anzahl von Ausgabeöffnungen auf.

Die Ausgabeöffnungen für das Druckmedium weisen bevorzugt einen Durchmesser kleiner 1mm, insbesondere kleiner 500µm, bevorzugt kleiner 100µm, insbesondere bevorzugt kleiner 60µm, weiter bevorzugt kleiner 30µm auf.

Weitere vorteilhafte Merkmale und bevorzugte Ausführungsformen werden im Folgenden anhand von Figuren und Ausführungsbeispielen beschrieben. Die Figuren zeigen 6 Ausführungsbeispiele, wobei zu jedem Ausführungsbeispiel jeweils mit einer ungeraden Figurennummer eine Seitenansicht gezeigt ist und mit gerader Figurennummer einer Draufsicht von aus der Ausgaberichtung der Substrate gezeigt ist:
Figuren 1/2: Ein erstes Ausführungsbeispiel einer erfindungsgemäßen Vorrichtung mit einer Hochdruckform;
Figuren 3/4: ein zweites Ausführungsbeispiel einer erfindungsgemäßen Vorrichtung mit selektiver Druckmediumaufnahmefläche;
Figuren 5/6: ein drittes Ausführungsbeispiel einer erfindungsgemäßen Vorrichtung mit einer Bewegungsvorrichtung;
Figuren 7/8: ein fünftes Ausführungsbeispiel einer erfindungsgemäßen Vorrichtung mit einem zusätzlichen Dispenskopf für Querlinien und
Figuren 9/10: ein sechstes Ausführungsbeispiel mit einem Begrenzungselement.

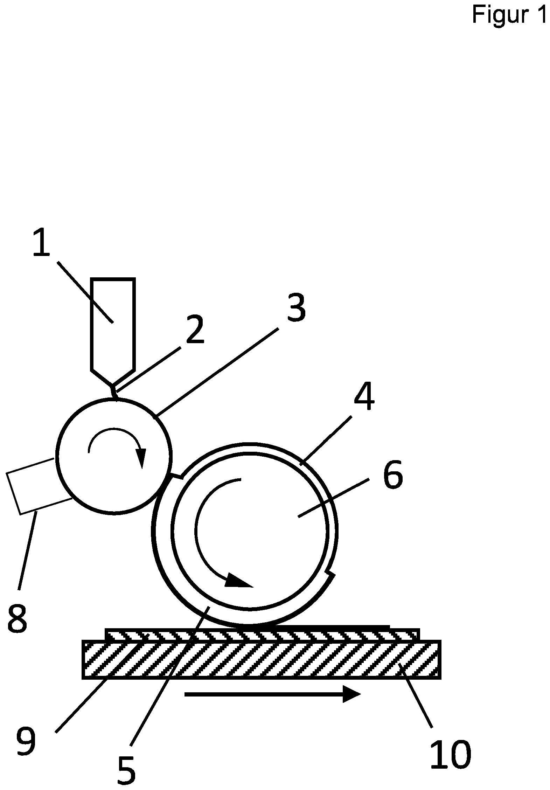

Die Figuren zeigen schematische, nicht maßstabsgetreue Darstellungen. In den Figuren 1 - 10 bezeichnen gleiche Bezugszeichen gleiche oder gleich wirkende Elemente.

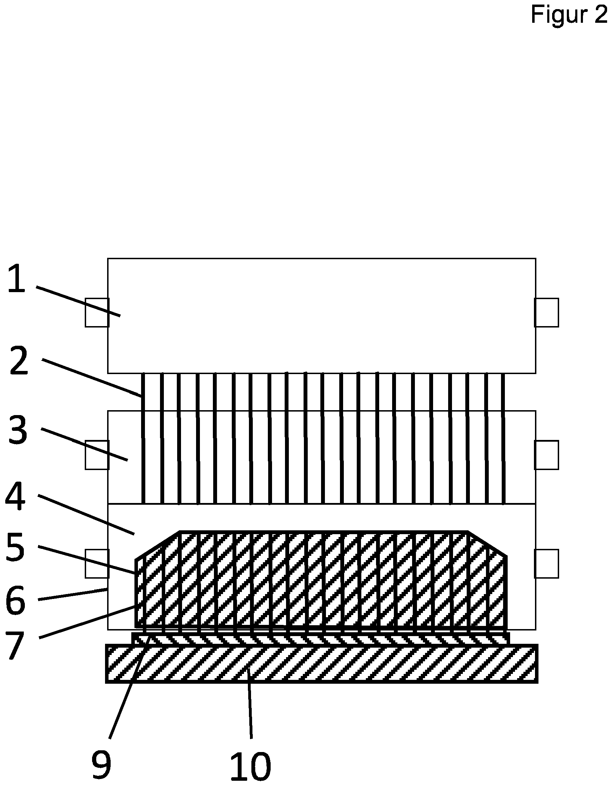

In Figur 1 ist ein erstes Ausführungsbeispiel einer erfindungsgemäßen Vorrichtung zum Aufbringen einer Struktur aus Druckmedium auf ein Substrat in Seitenansicht und in Figur 2 in Draufsicht gezeigt. Die Zeichenebene der Figur 2 steht somit senkrecht zur Zeichenebene der Figur 1 und zeigt eine Draufsicht aus der Ausgaberichtung der Substrate, d.h. Figur 2 zeigt eine Ansicht vom rechten Rand der Figur 1 ausgehend auf die Vorrichtung. Diese Anordnung der Ansichten trifft auch auf die weiteren Figurenpaare zu.

Die Vorrichtung weist einen motorisch angetriebenen, drehbaren Transferzylinder 3, eine Druckmedium-Zuführeinheit mit einer Dispenseinheit 1 und eine Substrat-Zuführeinheit 10 auf.

Die Substrat-Zuführeinheit 10 ist vorliegend als Shuttle ausgebildet, welche linear entlang der unterhalb der Substrat-Zuführeinheit 10 mit einem Pfeil gekennzeichneten Richtung motorisch bewegt werden kann, vorliegend mit einem Förderband. Auf dem Shuttle der Substrat-Zuführeinheit 10 befindet sich ein Substrat 9, welches vorliegend als Siliziumwafer ausgebildet ist, welcher bereits als Precursor bei der Solarzellenherstellung gefertigt wurde und insbesondere Dotierungen zur Ausbildung eines Emitters und einer Basis aufweisen. In einem alternativen Ausführungsbeispiel ist die Substrat-Zuführungseinheit 10 zum Zuführen eines bahnförmigen Substrats ausgebildet, auf welches die Drucklinien aufgebracht werden.

Die Dispenseinheit 1 der Druckmedium-Zuführeinheit weist eine Mehrzahl nebeneinander angeordneter Ausgabeöffnungen für das Druckmedium auf. Die Ausgabeöffnungen sind entlang einer geraden Linie angeordnet, welche in der Darstellung gemäß Figur 1 senkrecht zur Zeichenebene steht.

Mittels der Dispenseinheit kann somit Druckmedium zu dem Transferzylinder 3 zugeführt werden, um gleichzeitig eine Mehrzahl paralleler und voneinander beabstandeter Druckmediumlinien 2 auf den Transferzylinder 3 aufzubringen, wie insbesondere in Figur 2 ersichtlich. Der Transferzylinder 3 ist somit als Dispens-Transferzylinder ausgebildet.

Die Vorrichtung weist weiterhin einen zweiten drehbaren Transferzylinder auf, welcher vorliegend als Druckzylinder 6 ausgebildet ist, um die Druckmediumlinien 2 auf das Substrat 9 zu übertragen.

Dispens-Transferzylinder 3 und Druckzylinder 6 weisen im Wesentlichen einen zylindrischen Aufbau auf und sind um die jeweilige Zylinderachse drehbar gelagert und gegenläufig motorisch angetrieben, wie durch die Kreisbogenpfeile gekennzeichnet.

Die Umfangsgeschwindigkeit des Druckzylinders 6 ist dabei derart auf die Bewegungsgeschwindigkeit der linearen Bewegung der Substrate mittels der Zuführeinheit 10 abgestimmt, dass zwischen Substrat 9 und Mantelfläche des Druckzylinders 6 keine oder zumindest allenfalls eine vernachlässigbare Relativgeschwindigkeit vorliegt.

Die Vorrichtung gemäß erstem Ausführungsbeispiel weist eine Längenbegrenzungseinheit auf, welche vorliegend eine Hochdruckform 4 aufweist, die auf der Mantelfläche des Druckzylinders 6 aufgebracht ist. Die Hochdruckform 4 weist einen erhöhten Bereich 5 auf, welcher aufgrund des gewählten Abstandes zu dem Dispens-Transferzylinder 3 mit den Druckmediumlinien 2 auf den Dispens-Transferzylinder 3 in Kontakt kommt. Der nicht erhöhte Bereich der Hochdruckform 4 ist hingegen derart von dem Dispens-Transferzylinder 3 beabstandet, dass kein Übertrag vom Druckmedium von dem Dispens-Transferzylinder 3 auf den Druckzylinder 6 erfolgt.

Der erhöhte Bereich 5 der Hochdruckform 4 wirkt somit als Längenbegrenzung, da lediglich Druckmediumlinien 2 mit einer vorgegebenen Länge auf das Substrat 9 übertragen werden, welche dem durch den erhöhten Bereich 5 abgedeckten Umfang des Druckzylinders 6 entspricht.

Mittels Längenbegrenzungseinheit wird somit die Länge der mittels der Dispenseinheit erzeugten Druckmediumlinien auf den Druckzylinder 6 begrenzt.

Überschüssiges Druckmedium, insbesondere diejenigen Bestandteile der Druckmediumlinien 2, welche nicht durch den erhöhten Bereich 5 der Hochdruckform 4 übertragen werden, wird mittels einer Druckmedium-Abführeinheit 8 von dem Dispens-Transferzylinder 3 entfernt und einem (nicht dargestellten) Druckmediumreservoir zugeführt, von welchem wiederum eine Rückführung in die Dispenseinheit 1 erfolgt.

In der Ausgestaltung gemäß der Figuren 1 und 2 werden somit sequenziell eine Mehrzahl von Shuttles, welche jeweils ein Substrat 9 tragen, dem Druckzylinder 6 zugeführt, sodass in schneller, sequenzieller Abfolge Substrate 9 mit parallelen Druckmediumlinien mit einer genau definierten Länge aufgebracht werden können.

In Figur 2 ist zur besseren Abgrenzung der erhöhte Bereich 5 der Hochdruckform 4 auf der Mantelfläche des Druckzylinders 6 schraffiert dargestellt und die in dieser Ansicht bereits auf das Substrat übertragenen Druckmediumlinien 2 sind zur besseren Zuordnung nochmals durch Striche auf der schraffierten Fläche 7 gekennzeichnet.

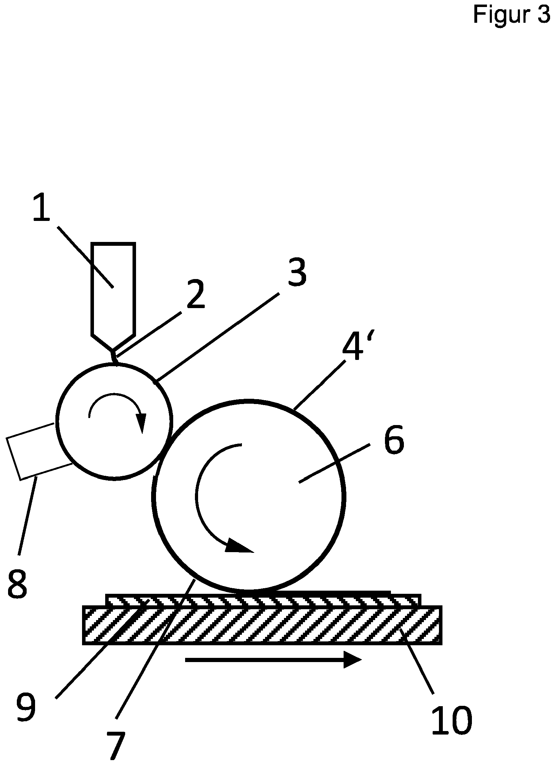

Die in den folgenden Figuren 3 - 10 dargestellten weiteren Ausführungsbeispiele weisen im Wesentlichen den gleichen Grundaufbau wie das erste Ausführungsbeispiel gemäß der Figuren 1 und 2 auf. Zur Vermeidung von Wiederholungen wird im Folgenden daher auf die wesentlichen Unterschiede eingegangen.

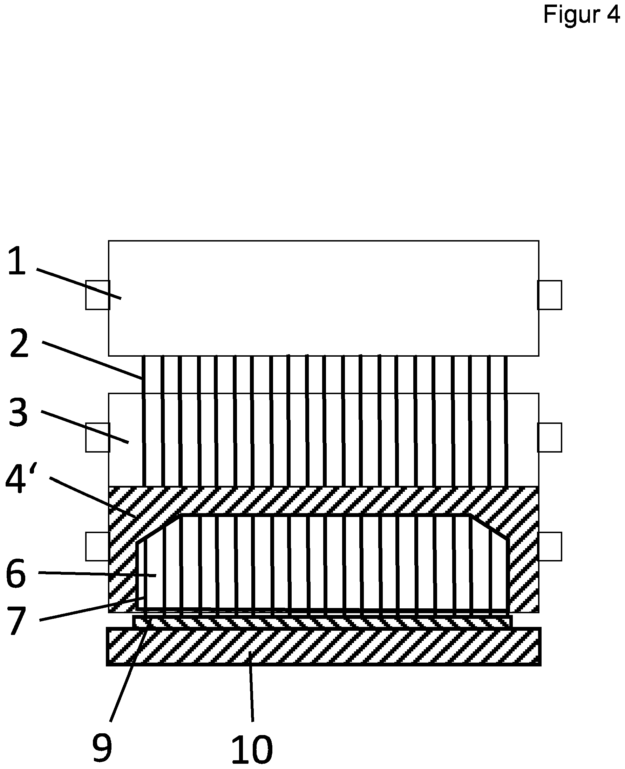

In den Figuren 3 und 4 ist ein zweites Ausführungsbeispiel einer erfindungsgemäßen Vorrichtung dargestellt, bei welchem die Längenbegrenzungseinheit eine selektive Druckmediumaufnahmefläche aufweist.

Die selektive Druckmediumaufnahmefläche ist auf der Mantelfläche des Druckzylinders 6 angeordnet. In einem alternativen Ausführungsbeispiel ist die selektive Aufnahmefläche auf der Mantelfläche des Dispens-Transferzylinders 3 angeordnet. In einer Weiterbildung dieses alternativen Ausführungsbeispiels erfolgt der Übertrag der Druckmediumlinien 2 unmittelbar von dem Dispens-Transferzylinder 3 auf das Substrat 9 unter Einsparung des Druckzylinders 6.

In dem Ausführungsbeispiel gemäß der Figuren 3 und 4 wird hingegen, wie bereits bei dem ersten Ausführungsbeispiel, kontinuierlich Druckmedium in Form der Druckmediumlinien 2, welche parallel und voneinander beabstandet sind, auf den Dispens-Transferzylinder 3 mittels der Dispenseinheit 1 aufgebracht. Die Mantelfläche des Druckzylinders 6 weist, wie in Figur 4 ersichtlich, eine Übertragungsfläche 7 auf, welche als Druckmediumaufnahmefläche ausgebildet ist, vorliegend mit Oberflächeneigenschaften, die hinsichtlich der Oberflächenenergie bzw. dem polaren und dispersen Anteil der Oberflächenenergie oder ihrer chemischen Eigenschaften eine gute Benetzung mit dem Druckmedium ermöglichen.

Für eine bei Herstellung von Halbleiterbauelementen übliche Druckpaste, typischerweise eine lösemittelbasierte, partikelhaltige Funktionspaste, wird hierdurch eine höhere Haftung und/oder bessere Benetzung an der Übertragungsfläche 7 erzielt, verglichen mit dem verbleibenden Bereich der Mantelfläche des Druckzylinders 6, welcher in Figur 4 schräg schraffiert dargestellt und mit dem Bezugszeichen 4- gekennzeichnet ist und somit einen Sperrbereich mit gegenüber dem Aufnahmebereich 7 geringerer Haftung und/oder geringerer Benetzung darstellt. Der Sperrbereich weist vorliegend eine Oberfläche auf, welche aufgrund ihrer chemischen Eigenschaften oder ihrer Oberflächenenergie zu einer geringen oder nicht realisierbaren Benetzung des Druckmediums führt..

Die Längenbegrenzung erfolgt vorliegend somit derart, dass bei Übertrag der Druckmediumlinien 2 von dem Dispens-Transferzylinder 3 auf den Druckzylinder 6 lediglich im Bereich der Übertragungsfläche 7, welche als Druckmediumaufnahmefläche ausgebildet ist, ein Übertrag von Druckmediumlinien erfolgt, wohingegen im Sperrbereich 4- keine Übertragung von Druckmediumlinien erfolgt.

Auch in diesem Ausführungsbeispiel werden auf dem Dispens-Transferzylinder 3 verbleibende Druckmediumlinien mittels der Druckmedium-Abführeinheit 8 entfernt.

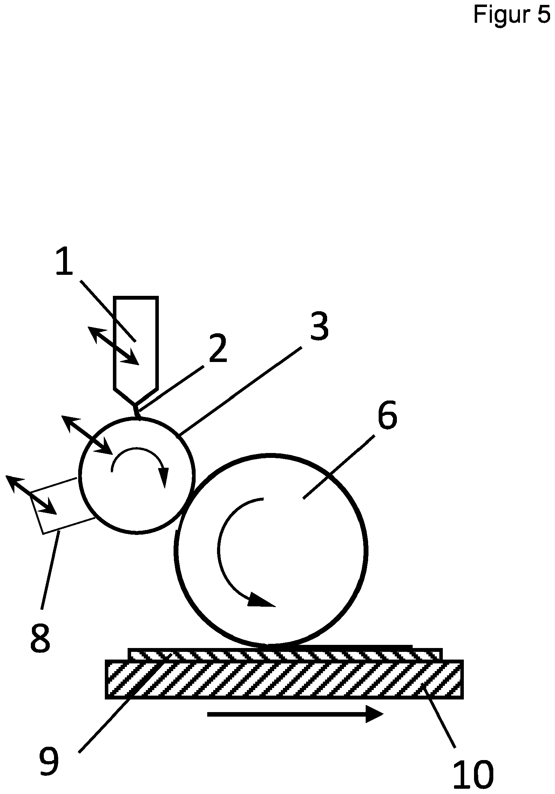

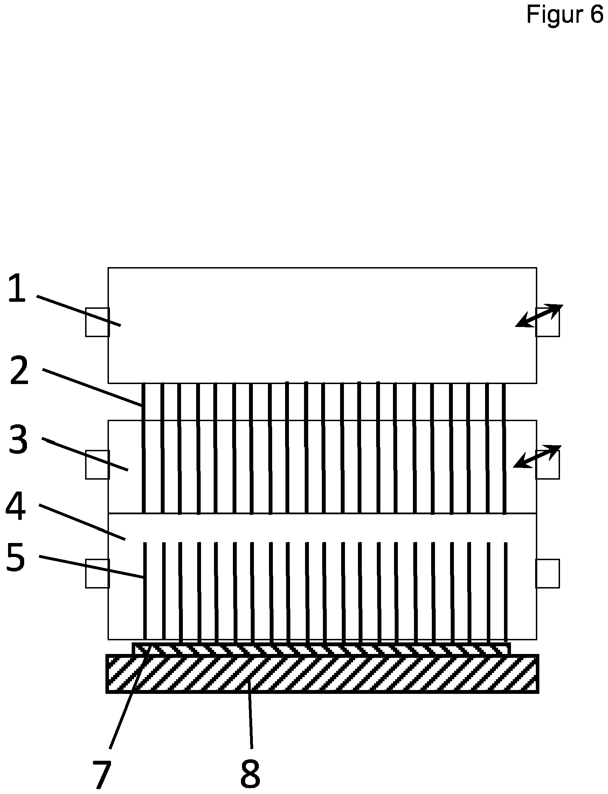

In den Figuren 5 und 6 ist ein drittes Ausführungsbeispiel dargestellt, bei welchem die Längenbegrenzungseinheit eine Bewegungsvorrichtung für den Dispens-Transferzylinder 3 aufweist. Vorliegend ist die Längenbegrenzungseinheit ausgebildet, um gemäß der dargestellten Doppelpfeile gleichzeitig den Dispens-Transferzylinder 3, die Dispenseinheit 1 und die Druckmedium-Abführeinheit 8 entlang der durch die Doppelpfeile gezeigten Richtungen von dem Druckzylinder 6 wegzubewegen oder zu diesem hin zu bewegen.

Auch in diesem Ausführungsbeispiel erfolgt somit kontinuierlich ein Auftragen von Druckmediumlinien 2 mittels der Dispenseinheit 1 auf den Dispens-Transferzylinder 3. In der gemäß Figur 5 dargestellten Übertragungsposition erfolgt eine Übertragung der Druckmediumlinien 2 von dem Dispens-Transferzylinder 3 auf den Druckzylinder 6.

Ist die gewünschte Länge der Druckmediumlinien erreicht, so werden motorisch mittels der Bewegungsvorrichtung Dispenseinheit 1, Dispens-Transferzylinder 3 und Druckmedium-Abführeinheit 8 von dem Druckzylinder 6 entfernt, sodass ein Abriss der Druckmediumlinien 2 im Übertragungsbereich zwischen Dispens-Transferzylinder 3 und Druckzylinder 6 erfolgt. Hierdurch wird die Länge der Druckmediumlinien auf den Druckzylinder 6 und somit nach Übertrag auch auf den Substrat 9 begrenzt.

Ein Vergleich der Figuren 6 und der Figuren 4 zeigt, dass bei dem Ausführungsbeispiel gemäß Figur 6 alle Startpunkte der Druckmediumlinien sowie alle Endpunkte der Druckmediumlinien zwingend auf einer gemeinsamen geraden Linie liegen.

Bei dem Ausführungsbeispiel gemäß Figur 4 und ebenso auch bei dem Ausführungsbeispiel gemäß Figur 2 kann hingegen durch die Hochdruckform 4 bzw. durch die Übertragungsfläche 7, welche als Druckmediumaufnahmefläche ausgebildet ist, eine beliebige Form vorgegeben werden, sodass insbesondere Druckmediumlinien im Randbereich kürzer ausgebildet werden können als in einem mittleren Bereich. Hierdurch ist es beispielsweise möglich, sogenannte Pseudo-Square-Wafer, welche abgeschrägte Ecken aufweisen, entsprechend der Wafer-Form mit Druckmediumlinien 2 angepasster Länge zu versehen.

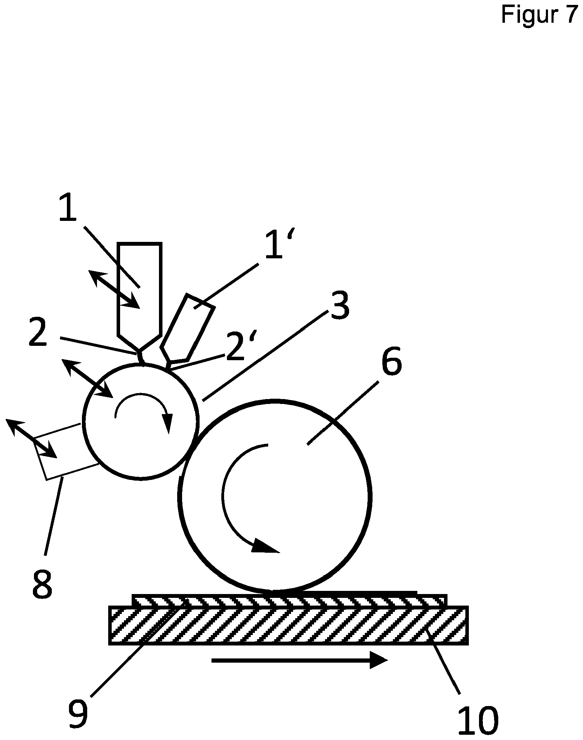

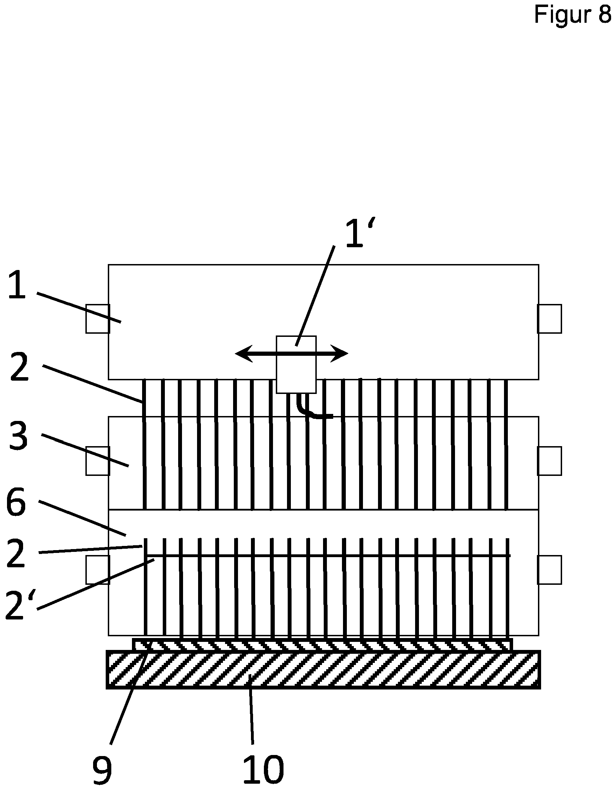

In den Figuren 7 und 8 ist ein fünftes Ausführungsbeispiel dargestellt, welches grundsätzlich wie das dritte Ausführungsbeispiel gemäß der Figuren 5 und 6 ausgebildet ist, insbesondere weist die Längenbegrenzungseinheit die vorbeschriebene Bewegungsvorrichtung zur Bewegung der Distanzeinheit 1, des Dispens-Transferzylinders 3 und der Druckmedium-Abführeinheit 8 relativ zu dem Druckzylinder 6 auf.

In dem in den Figuren 7 und 8 dargestellten Ausführungsbeispiel weist die Vorrichtung zusätzlich eine Querlinien-Dispenseinheit 1- zur Ausgabe von Querlinien 2- auf, welche senkrecht zu den Druckmediumlinien 2 stehen, auf.

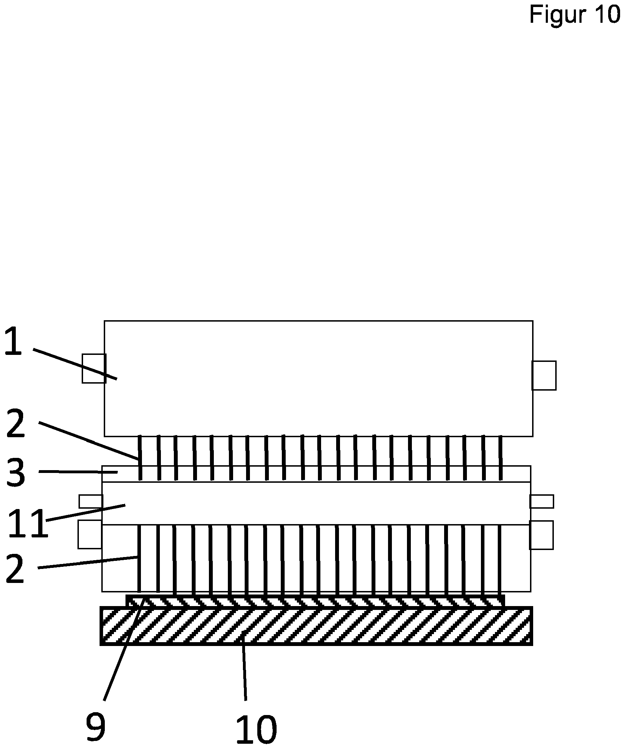

Wie in Figur 8 ersichtlich, ist die Querlinien-Dispenseinheit 9 daher in axialer Richtung bezüglich der Drehachse des Dispens-Transferzylinders 3. Es ist eine Verschiebeeinheit motorisch verschiebbar, d. h. in Figur 10 nach rechts und links verschiebbar. Hierdurch wird eine Querlinie 2- auf dem Dispens-Transferzylinder 3 aufgebracht und von diesem auf den Druckzylinder 6 übertragen.

Die Querlinien werden dabei im laufenden Betrieb aufgebracht, wobei der Winkel so gewählt wird, dass die Drehbewegung des Zylinders ausgeglichen wird, d.h. im Ergebnis parallele Linien zur Zylinderachse auf den Transferzylinder dispensiert werden.

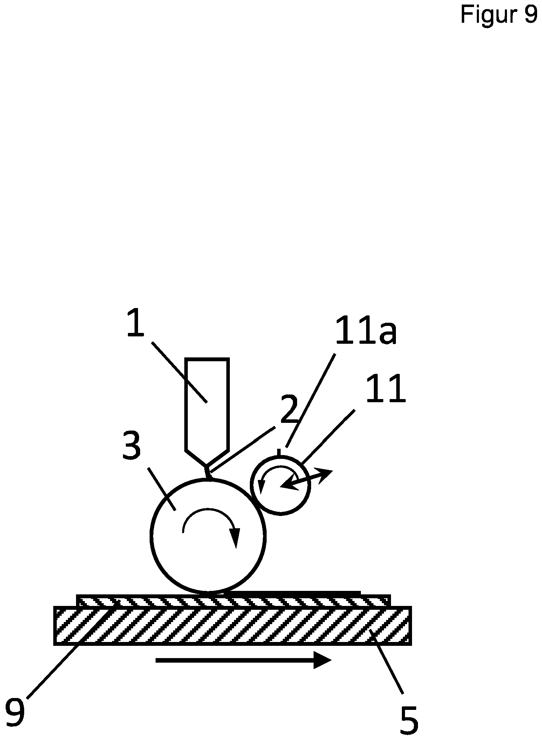

In den Figuren 9 und 10 ist ein sechstes Ausführungsbeispiel einer erfindungsgemäßen Vorrichtung dargestellt. Die Vorrichtung gemäß diesem Ausführungsbeispiel weist jedoch keinen Druckzylinder 6 auf. Hingegen werden die Druckmediumlinien 2 direkt von dem Dispens-Transferzylinder 3 auf das Substrat 9 übertragen. Auch hier werden kontinuierlich parallele, voneinander beabstandete Druckmediumlinien 2 mittels der Dispenseinheit 1 auf den Dispens-Transferzylinder 3 aufgebracht.

Die Längenbegrenzungseinheit weist vorliegend ein Trennrakel 11a auf, welches auf einem Trennzylinder 11 angeordnet ist. Der Trennzylinder 11 bewegt sich gegenläufig zu dem Dispens-Transferzylinder und ist derart beabstandet, dass lediglich das Trennrakel 11a mit den Druckmediumlinien 2 auf der Oberfläche des Dispens-Transferzylinders 3 in Kontakt kommt. Mittels des Trennrakels 11a erfolgt somit eine Längenbegrenzung der Druckmediumlinien.

In einer alternativen Ausführungsform weist der Trennzylinder 11 kein Trennrakel 11a auf. Die Längenbegrenzungseinheit weist hingegen zusätzlich eine Bewegungseinheit auf, um den Trennzylinder 11 gemäß dem dargestellten Doppelpfeil von dem Dispens-Transferzylinder 3 wegzubewegen und zu diesem hin zu bewegen. Zur Längenbegrenzung wird somit kurzzeitig mittels der Bewegungseinheit der Trennzylinder 11 in Kontakt mit der Oberfläche des Dispens-Transferzylinders 3 gebracht, sodass die Druckmediumlinien 2 unterbrochen werden.

### Bezugszeichenliste

- 1: Dispenseinheit
- 1': Querlinien-Dispenseinheit
- 2: Druckmediumlinien
- 2': Querlinie
- 3: Dispens-Transferzylinder
- 4: Hochdruckform
- 4': Sperrbereich
- 5: erhöhter Bereich der Hochdruckform 4
- 6: Druckzylinder
- 7: Übertragungsfläche
- 8: Druckmedium-Abführeinheit
- 9: Substrat
- 10: Substrat-Zuführeinheit
- 11: Trennzylinder
- 11a: Trennrakel

## Patentansprüche

1. Vorrichtung zum Aufbringen einer Struktur aus Druckmedium auf ein Substrat (9),
mit einem drehbaren Transferzylinder, einer Druckmedium-Zuführeinheit und einer Substrat-Zuführeinheit (10), wobei die Druckmedium-Zuführeinheit ausgebildet ist, Druckmedium zu dem Transferzylinder zuzuführen und die Vorrichtung ausgebildet ist, Druckmedium mittelbar oder unmittelbar von dem Transferzylinder auf das mittels der Substrat-Zuführeinheit (10) zugeführte Substrat (9) zu übertragen, um die Struktur aus Druckmedium auf dem Substrat (9) auszubilden,
**dadurch gekennzeichnet,**
**dass** die Druckmedium-Zuführeinheit eine Dispenseinheit (1) mit einer Mehrzahl von Ausgabeöffnungen für Druckmedium aufweist, welche mit dem als Dispens-Transferzylinder (3) ausgebildeten Transferzylinder zusammenwirkend ausgebildet ist, um gleichzeitig eine Mehrzahl paralleler und voneinander beabstandeter Druckmediumlinien (2) von Druckmedium auf den Dispens-Transferzylinder (3) aufzubringen und
**dass** die Vorrichtung zumindest eine Längenbegrenzungseinheit aufweist, welche ausgebildet ist, die Länge der mittels der Dispenseinheit (1) erzeugten Druckmediumlinien (2) auf dem Dispens-Transferzylinder (3) und/oder einem weiteren Transferzylinder der Vorrichtung zu begrenzen.

2. Vorrichtung nach Anspruch 1,
**dadurch gekennzeichnet,**
**dass** die Längenbegrenzungseinheit zumindest ein Begrenzungselement aufweist, welches auf der Mantelfläche des Dispens-Transferzylinders oder eines weiteren Transferzylinders angeordnet ist, um die Länge der Druckmediumlinien (2) zu begrenzen, insbesondere,
**dass** die Längenbegrenzungseinheit ein Hochdruckform mit zumindest einem Begrenzungselement aufweist, welche auf der Mantelfläche des Dispens-Transferzylinders oder eines weiteren Transferzylinders angeordnet ist.

3. Vorrichtung nach einem der vorangegangenen Ansprüche,
**dadurch gekennzeichnet,**
**dass** die Vorrichtung einen zweiten drehbaren Transferzylinder aufweist, welcher mit dem Dispens-Transferzylinder zusammenwirkend ausgebildet und angeordnet ist, um die Druckmediumlinien (2) zumindest teilweise von dem Dispens-Transferzylinder (3) aufzunehmen und auf das Substrat (9) zu übertragen.

4. Vorrichtung nach einem der vorangegangenen Ansprüche,
**dadurch gekennzeichnet,**
**dass** die Längenbegrenzungseinheit eine Hochdruckform (4) aufweist, welche auf der Mantelfläche des Dispens-Transferzylinders oder eines weiteren Transferzylinders angeordnet ist, um die Länge der Druckmediumlinien (2) zu begrenzen, insbesondere,
**dass** die Hochdruckform (4) auf der Mantelfläche eines zweiten Transferzylinders gemäß Anspruch 3 angeordnet ist.

5. Vorrichtung nach einem der vorangegangenen Ansprüche,
**dadurch gekennzeichnet,**
**dass** die Längenbegrenzungseinheit eine selektive Druckmediumaufnahmefläche aufweist, welche auf der Mantelfläche des Dispens-Transferzylinders oder eines weiteren Transferzylinders angeordnet ist, um die Länge der Druckmediumlinien (2) zu begrenzen,
wobei die selektive Druckmediumaufnahmefläche zumindest einen Aufnahmebreich mit höherer Haftung für das Druckmedium und/oder einer für das Druckmedium besser benetzbaren Oberfläche
und zumindest einen Sperrbereich (4') mit gegenüber dem Aufnahmebereich geringerer Haftung für das Druckmedium und/oder einer für das Druckmedium geringer oder nicht benetzbaren Oberfläche aufweist, um mittels des Sperrbereichs die Länge der Druckmediumlinien (2) im Aufnahmebereich zu begrenzen.

6. Vorrichtung nach einem der vorangegangenen Ansprüche,
**dadurch gekennzeichnet,**
**dass** die Längenbegrenzungseinheit eine Bewegungsvorrichtung für den Dispens-Transferzylinder (3) aufweist, um den Dispens-Transferzylinder (3) relativ zu einem oder mehreren der Elemente
- Dispenseinheit (1),
- Substrat (9),
- einem weiteren Transferzylinder, insbesondere dem zweiten Transferzylinder gemäß Anspruch 3,
zu bewegen, so dass aufgrund der Relativbewegung eine Unterbrechung der Druckmediumlinien (2) erfolgt.

7. Vorrichtung nach einem der vorangegangenen Ansprüche,
**dadurch gekennzeichnet,**
**dass** die Längenbegrenzungseinheit eine Trennvorrichtung mit zumindest einem Trennelement aufweist, welche mit dem Dispens-Transferzylinder (3) und/oder einem weiteren Transferzylinder zusammenwirkend ausgebildet ist, um mittels des Trennelements eine Unterbrechung der Druckmediumlinien (2) auf dem Dispens-Transferzylinder (3) und/oder einem weiteren Transferzylinder zu erzeugen,
insbesondere,
**dass** das Trennelement als Trennrakel (11a) ausgebildet ist, bevorzugt, dass der Trennrakel (11a) auf einem drehbaren Trennzylinder (11) angeordnet ist.

8. Vorrichtung nach einem der vorangegangenen Ansprüche,
**dadurch gekennzeichnet,**
**dass** die Druckmedium-Zuführeinheit eine Querlinien-Ausgabeeinheit, insbesondere eine zweite Dispenseinheit, aufweist, welche ausgebildet ist, zusätzlich zu den parallelen Druckmediumlinien (2) eine oder mehrere Querlinien aus Druckmedium auf den Dispens-Transferzylinder (3) oder einen weiteren Transferzylinder aufzubringen, wobei die Querlinie (2') nicht parallel zu den parallelen Druckmediumlinien (2) ist, insbesondere mit den parallelen Druckmediumlinien (2) einen Winkel im Bereich 85° bis 95° einschließt.

9. Vorrichtung nach einem der vorangegangenen Ansprüche,
**dadurch gekennzeichnet,**
**dass** die Längenbegrenzungseinheit eine Druckmedium-Abführeinheit (8) aufweist, um überschüssiges Druckmedium der Druckmediumlinien (2) von dem Dispens-Transferzylinder (3) und/oder einem weiteren Transferzylinder abzuführen und bevorzugt das abgeführte Druckmedium der Dispenseinheit zuzuführen.

10. Verfahren zum Aufbringen einer Struktur aus Druckmedium auf ein Substrat (9), mit den Verfahrensschritten
A. Aufbringen von Druckmedium auf einen drehbaren Transferzylinder und
B. Mittelbares oder unmittelbares Übertragen des Druckmediums von dem Transferzylinder auf das Substrat (9),
**dadurch gekennzeichnet,**
**dass** in Verfahrensschritt A das Druckmedium mittels Dispensen in einer Mehrzahl paralleler und voneinander beabstandeter Druckmediumlinien (2) auf den als Dispens-Transferzylinder (3) ausgebildeten Transferzylinder aufgebracht wird und
**dass** mittels einer Längenbegrenzungseinheit die Länge der Druckmediumlinien (2) auf dem Dispens-Transferzylinder (3) und/oder einem weiteren Transferzylinder vor Durchführen von Verfahrensschritt B begrenzt wird.

11. Verfahren nach Anspruch 10,
**dadurch gekennzeichnet,**
**dass** das Aufbringen der Druckmediumlinien (2) auf eine Mehrzahl sequentiell zugeführter Substrate erfolgt und dass währenddessen ein kontinuierliches Dispensen von Druckmedium auf den Dispens-Transferzylinder (3) erfolgt.

12. Verfahren nach einem der Ansprüche 10 bis 11,
**dadurch gekennzeichnet,**
**dass** die Druckmediumlinen von dem Dispens-Transferzylinder (3) auf einen zweiten Transferzylinder übertragen werden und bevorzugt von dem zweiten Transferzylinder auf das Substrat (9) übertragen werden, insbesondere,
**dass** die Längenbegrenzung der Druckmediumlinien (2) an und/oder auf dem zweiten Transferzylinder erfolgt.

13. Verfahren nach einem der Ansprüche 10 bis 12,
**dadurch gekennzeichnet,**
**dass** die Längenbegrenzung mittels eines oder mehrerer der Verfahrensschritte aus der Liste
- Verwenden zumindest eines Begrenzungselementes, welches auf der Mantelfläche des Dispens-Transferzylinders oder eines weiteren Transferzylinders angeordnet ist,
- Verwenden einer Hochdruckform mit zumindest einem Begrenzungselement, welches auf der Mantelfläche des Dispens-Transferzylinders oder eines weiteren Transferzylinders angeordnet ist,
erfolgt,
- Verwenden einer Hochdruckform (4), welche auf der Mantelfläche des Dispens-Transferzylinders oder eines weiteren Transferzylinders angeordnet ist,
- Verwenden einer selektiven Druckmediumaufnahmefläche, welche auf der Mantelfläche des Dispens-Transferzylinders oder eines weiteren Transferzylinders angeordnet ist, wobei die selektive Druckmedium-aufnahmefläche zumindest einen Aufnahmebreich mit höherer Haftung für das Druckmedium und/oder einer für das Druckmedium besser benetzbaren Oberfläche
und zumindest einen Sperrbereich (4') mit gegenüber dem Aufnahmebereich geringerer Haftung für das Druckmedium und/oder einer für das Druckmedium geringer oder nicht benetzbaren Oberfläche aufweist, so dass mittels des Sperrbereichs die Länge der Druckmediumlinien (2) im Aufnahmebereich begrenzt werden,
- Bewegen des Dispens-Transferzylinders relativ zu einem oder mehreren der Elemente
- Dispenseinheit (1),
- Substrat (9),
- einem weiteren Transferzylinder, insbesondere dem zweiten Transferzylinder gemäß Anspruch 12,
so dass aufgrund der Relativbewegung die Druckmediumlinien (2) unterbrochen werden,
erfolgt.

14. Verfahren nach einem der Ansprüche 10 bis 13,
**dadurch gekennzeichnet,**
**dass** die Druckmediumlinien (2) auf eine Länge begrenzt werden, welche kleiner ist als die Länge des Substrats.

15. Verfahren nach einem der Ansprüche 10 bis 14,
**dadurch gekennzeichnet,**
**dass** ein Druckmedium verwendet wird, welches Halbleiter-Dotierstoffe und/oder Metallpartikel enthält,
**dass** als Substrat ein Halbleitersubstrat oder ein mit einer Halbleiterschicht beschichtetes Substrat (9) verwendet wird und
**dass** mittels des Verfahrens eine Struktur zum Ausbilden einer metallischen Kontaktierungsstruktur und/oder einer Dotierstruktur zum Erzeugen selektiver Dotierbereiche in dem Halbleitersubstrat ausgebildet wird.

## Claims

1. Apparatus for applying a structure made of printing medium to a substrate (9),
having a rotatable transfer cylinder, a printing medium supply unit and a substrate supply unit (10), wherein the printing medium supply unit is configured to supply printing medium to the transfer cylinder and the apparatus is configured to transfer printing medium indirectly or directly from the transfer cylinder to the substrate (9) supplied by means of the substrate supply unit (10), in order to form the structure made of printing medium on the substrate (9),
**characterised in that**
the printing medium supply unit has a dispensing unit (1) having a plurality of discharge openings for printing medium, which dispensing unit is configured to co-operate with the transfer cylinder, which is configured as a dispensing-transfer cylinder (3), in order to effect simultaneous application of a plurality of parallel and mutually spaced printing medium lines (2) of printing medium to the dispensing-transfer cylinder (3); and
the apparatus has at least one length-limiting unit which is configured to limit the length of the printing medium lines (2) generated by means of the dispensing unit (1) on the dispensing-transfer cylinder (3) and/or on a further transfer cylinder of the apparatus.

2. Apparatus according to claim 1,
**characterised in that**
the length-limiting unit has at least one limiting element which is arranged on the lateral surface of the dispensing-transfer cylinder or of a further transfer cylinder in order to limit the length of the printing medium lines (2); especially
the length-limiting unit has a relief printing plate having at least one limiting element which is arranged on the lateral surface of the dispensing-transfer cylinder or of a further transfer cylinder.

3. Apparatus according to either one of the preceding claims, **characterised in that**
the apparatus has a second rotatable transfer cylinder which is configured and arranged to co-operate with the dispensing-transfer cylinder in order to receive the printing medium lines (2), at least in part, from the dispensing-transfer cylinder (3) and transfer them to the substrate (9).

4. Apparatus according to any one of the preceding claims, **characterised in that**
the length-limiting unit has a relief printing plate (4) which is arranged on the lateral surface of the dispensing-transfer cylinder or of a further transfer cylinder in order to limit the length of the printing medium lines (2); especially
the relief printing plate (4) is arranged on the lateral surface of a second transfer cylinder according to claim 3.

5. Apparatus according to any one of the preceding claims, **characterised in that**
the length-limiting unit has a selective printing medium receiving surface which is arranged on the lateral surface of the dispensing-transfer cylinder or of a further transfer cylinder in order to limit the length of the printing medium lines (2),
wherein the selective printing medium receiving surface has at least one receiving region having greater adhesiveness towards the printing medium and/or a surface that is better wettable by the printing medium
and at least one blocking region (4') having lower adhesiveness towards the printing medium in comparison with the receiving region and/or a surface that is less wettable or not wettable by the printing medium in order, by means of the blocking region, to limit the length of the printing medium lines (2) in the receiving region.

6. Apparatus according to any one of the preceding claims, **characterised in that**
the length-limiting unit has a movement device for the dispensing-transfer cylinder (3) in order to move the dispensing-transfer cylinder (3) relative to one or more of the elements
- dispensing unit (1),
- substrate (9),
- a further transfer cylinder, especially the second transfer cylinder according to claim 3,
so that the relative movement gives rise to an interruption in the printing medium lines (2).

7. Apparatus according to any one of the preceding claims, **characterised in that**
the length-limiting unit has a separating device having at least one separating element, which separating device is configured to co-operate with the dispensing-transfer cylinder (3) and/or with a further transfer cylinder in order, by means of the separating element, to generate an interruption in the printing medium lines (2) on the dispensing-transfer cylinder (3) and/or on a further transfer cylinder; especially,
the separating element is configured as a separating blade (11a); preferably,
the separating blade (11a) is arranged on a rotatable separating cylinder (11).

8. Apparatus according to any one of the preceding claims, **characterised in that**
the printing medium supply unit has a transverse line discharge unit, especially a second dispensing unit, which is configured to apply, in addition to the parallel printing medium lines (2), one or more transverse lines made of printing medium to the dispensing-transfer cylinder (3) or to a further transfer cylinder, the transverse line (2') not being parallel to the parallel printing medium lines (2), especially enclosing an angle in the range of from 85° to 95° with the parallel printing medium lines (2).

9. Apparatus according to any one of the preceding claims, **characterised in that**
the length-limiting unit has a printing medium removal unit (8) in order to remove excess printing medium of the printing medium lines (2) from the dispensing-transfer cylinder (3) and/or from a further transfer cylinder and preferably to supply the removed printing medium to the dispensing unit.

10. Method of applying a structure made of printing medium to a substrate (9), comprising the method steps:
A. application of printing medium to a rotatable transfer cylinder and
B. indirect or direct transfer of the printing medium from the transfer cylinder to the substrate (9),
**characterised in that**
in method step A the printing medium is applied to the transfer cylinder, which is configured as a dispensing-transfer cylinder (3), by being dispensed in a plurality of parallel and mutually spaced printing medium lines (2); and
the length of the printing medium lines (2) on the dispensing-transfer cylinder (3) and/or on a further transfer cylinder is limited by means of a length-limiting unit before method step B is carried out.

11. Method according to claim 10,
**characterised in that**
the printing medium lines (2) are applied to a plurality of sequentially supplied substrates, and meanwhile continuous dispensing of printing medium to the dispensing-transfer cylinder (3) takes place.

12. Method according to either one of claims 10 and 11,
**characterised in that**
the printing medium lines are transferred from the dispensing-transfer cylinder (3) to a second transfer cylinder and preferably from the second transfer cylinder to the substrate (9); especially
the limitation of the length of the printing medium lines (2) is effected at and/or on the second transfer cylinder.

13. Method according to any one of claims 10 to 12,
**characterised in that**
the length-limitation is effected by means of one or more of the method steps from the list
- use of at least one limiting element which is arranged on the lateral surface of the dispensing-transfer cylinder or of a further transfer cylinder,
- use of a relief printing plate having at least one limiting element which is arranged on the lateral surface of the dispensing-transfer cylinder or of a further transfer cylinder,
- use of a relief printing plate (4) which is arranged on the lateral surface of the dispensing-transfer cylinder or of a further transfer cylinder,
- use of a selective printing medium receiving surface which is arranged on the lateral surface of the dispensing-transfer cylinder or of a further transfer cylinder, the selective printing medium receiving surface having at least one receiving region having greater adhesiveness towards the printing medium and/or a surface that is better wettable by the printing medium and at least one blocking region (4') having lower adhesiveness towards the printing medium in comparison with the receiving region and/or a surface that is less wettable or not wettable by the printing medium so that, by means of the blocking region, the length of the printing medium lines (2) in the receiving region is limited,
- movement of the dispensing-transfer cylinder relative to one or more of the elements
- dispensing unit (1),
- substrate (9),
- a further transfer cylinder, especially the second transfer
cylinder according to claim 12,
so that, as a result of the relative movement, the printing medium lines (2) are interrupted.

14. Method according to any one of claims 10 to 13,
**characterised in that**
the printing medium lines (2) are limited to a length which is smaller than the length of the substrate.

15. Method according to any one of claims 10 to 14,
**characterised in that**
a printing medium is used which contains semiconductor dopants and/or metal particles;
a semiconductor substrate or a substrate (9) coated with a semiconductor layer is used as substrate; and
by means of the method, a structure for forming a metallic contacting structure and/or a doping structure for generating selective doping regions in the semiconductor substrate is formed.

## Revendications

1. Dispositif pour l'application d'une structure en moyen d'impression sur un substrat (9),
comprenant un cylindre de transfert rotatif, une unité d'alimentation en moyen d'impression et une unité d'alimentation en substrat (10), dans lequel l'unité d'alimentation en moyen d'impression est agencée pour amener du moyen d'impression au cylindre de transfert et le dispositif est agencé pour transférer du moyen d'impression indirectement ou directement du cylindre de transfert sur le substrat (9) amené au moyen de l'unité d'alimentation en substrat (10) pour former la structure en moyen d'impression sur le substrat (9),
**caractérisé en ce que**
l'unité d'alimentation en moyen d'impression présente une unité de distribution (1) comprenant une pluralité d'ouvertures de sortie pour moyen d'impression, laquelle est agencée de manière à coopérer avec le cylindre de transfert conformé en cylindre de transfert de distribution (3) pour appliquer simultanément une pluralité de lignes de moyen d'impression (2) parallèles et distantes les unes des autres de moyen d'impression sur le cylindre de transfert de distribution (3), et le dispositif présente au moins une unité de limitation de longueur qui est agencée pour limiter la longueur des lignes de moyen d'impression (2) produites au moyen de l'unité de distribution (1) sur le cylindre de transfert de distribution (3) et/ou un autre cylindre de transfert du dispositif.

2. Dispositif selon la revendication 1,
**caractérisé en ce que**
l'unité de limitation de longueur présente au moins un élément de limitation qui est disposé sur la surface d'enveloppe du cylindre de transfert de distribution ou d'un autre cylindre de transfert pour limiter la longueur des lignes de moyen d'impression (2), en particulier,
l'unité de limitation de longueur présente une forme d'impression en relief comprenant au moins un élément de limitation, laquelle est disposée sur la surface d'enveloppe du cylindre de transfert de distribution ou d'un autre cylindre de transfert.

3. Dispositif selon l'une des revendications précédentes,
**caractérisé en ce que**
le dispositif présente un deuxième cylindre de transfert rotatif qui est agencé de manière à coopérer avec le cylindre de transfert de distribution et est disposé pour recevoir au moins en partie du cylindre de transfert de distribution (3) des lignes de moyen d'impression (2) et les transférer sur le substrat (9).

4. Dispositif selon l'une des revendications précédentes,
**caractérisé en ce que**
l'unité de limitation de longueur présente une forme d'impression en relief (4) qui est disposée sur la surface d'enveloppe du cylindre de transfert de distribution ou d'un autre cylindre de transfert pour limiter la longueur des lignes de moyen d'impression (2), en particulier,
la forme d'impression en relief (4) est disposée sur la surface d'enveloppe d'un deuxième cylindre de transfert selon la revendication 3.

5. Dispositif selon l'une des revendications précédentes,
**caractérisé en ce que**
l'unité de limitation de longueur présente une surface de réception de moyen d'impression sélective qui est disposée sur la surface d'enveloppe du cylindre de transfert de distribution ou d'un autre cylindre de transfert pour limiter la longueur des lignes de moyen d'impression (2),
dans lequel la surface de réception de moyen d'impression sélective présente au moins une zone de réception avec une adhérence plus élevée pour le moyen d'impression et/ou une surface présentant une meilleure mouillabilité pour le moyen d'impression,
et au moins une zone de blocage (4') avec une adhérence moindre par rapport à la zone de réception pour le moyen d'impression et/ou une surface présentant une mouillabilité moindre ou ne présentant aucune mouillabilité pour le moyen d'impression pour limiter au moyen de la zone de blocage la longueur des lignes de moyen d'impression (2) dans la zone de réception.

6. Dispositif selon l'une des revendications précédentes,
**caractérisé en ce que**
l'unité de limitation de longueur présente un dispositif de déplacement pour le cylindre de transfert de distribution (3) pour déplacer le cylindre de transfert de distribution (3) par rapport à un ou plusieurs des éléments suivants
- unité de distribution (1),
- substrat (9),
- un autre cylindre de transfert, en particulier le deuxième cylindre de transfert selon la revendication 3,
de telle sorte qu'une interruption des lignes de moyen d'impression (2) soit effectuée en raison du déplacement relatif.

7. Dispositif selon l'une des revendications précédentes,
**caractérisé en ce que**
l'unité de limitation de longueur présente un dispositif de séparation comprenant au moins un élément de séparation, lequel est agencé de manière à coopérer avec le cylindre de transfert de distribution (3) et/ou un autre cylindre de transfert pour produire au moyen de l'élément de séparation une interruption des lignes de moyen d'impression (2) sur le cylindre de transfert de distribution (3) et/ou un autre cylindre de transfert,
en particulier,
l'élément de séparation est conformé en raclette de séparation (11a), de préférence la raclette de séparation (11a) est disposée sur un cylindre de séparation (11) rotatif.

8. Dispositif selon l'une des revendications précédentes,
**caractérisé en ce que**
l'unité d'alimentation en moyen d'impression présente une unité de sortie de lignes transversales, en particulier une deuxième unité de distribution, laquelle est agencée pour appliquer, en plus des lignes de moyen d'impression (2) parallèles, une ou plusieurs lignes transversales en moyen d'impression sur le cylindre de transfert de distribution (3) ou un autre cylindre de transfert, dans lequel la ligne transversale (2') n'est pas parallèle aux lignes de moyen d'impression (2) parallèles, en particulier forme avec les lignes de moyen d'impression (2) parallèles un angle dans la plage de 85° à 95°.

9. Dispositif selon l'une des revendications précédentes,
**caractérisé en ce**
**que** l'unité de limitation de longueur présente une unité d'évacuation de moyen d'impression (8) pour évacuer un excédent de moyen d'impression des lignes de moyen d'impression (2) du cylindre de transfert de distribution (3) et/ou d'un autre cylindre de transfert et de préférence pour amener à l'unité de distribution le moyen d'impression évacué.

10. Procédé pour appliquer une structure en moyen d'impression sur un substrat (9), comprenant les étapes de procédé suivantes
A. application de moyen d'impression sur un cylindre de transfert rotatif et
B. transfert indirect ou direct du moyen d'impression du cylindre de transfert sur le substrat (9),
**caractérisé en ce que**
à l'étape de procédé A, le moyen d'impression est appliqué au moyen de distributeurs en une pluralité de lignes de moyen d'impression (2) parallèles et distantes les unes des autres sur le cylindre de transfert conformé en cylindre de transfert de distribution (3), et
la longueur des lignes de moyen d'impression (2) est limitée sur le cylindre de transfert de distribution (3) et/ou un autre cylindre de transfert avant la mise en œuvre de l'étape de procédé B au moyen d'une unité de limitation de longueur.

11. Procédé selon la revendication 10,
**caractérisé en ce que**
l'application des lignes de moyen d'impression (2) est effectuée sur une pluralité de substrats amenés de manière séquentielle, et pendant ce temps une distribution continue de moyen d'impression est effectuée sur le cylindre de transfert de distribution (3).

12. Procédé selon l'une des revendications 10 à 11,
**caractérisé en ce que**
les lignes de moyen d'impression sont transférées du cylindre de transfert de distribution (3) sur un deuxième cylindre de transfert et de préférence sont transférées du deuxième cylindre de transfert sur le substrat (9), en particulier,
la limitation de longueur des lignes de moyen d'impression (2) est effectuée en et/ou sur le deuxième cylindre de transfert.

13. Procédé selon l'une des revendications 10 à 12,
**caractérisé en ce que**
la limitation de longueur est effectuée au moyen d'une ou de plusieurs des étapes de procédé de la liste suivante :
- utilisation d'au moins un élément de limitation qui est disposé sur la surface d'enveloppe du cylindre de transfert de distribution ou d'un autre cylindre de transfert,
- utilisation d'une forme d'impression en relief comprenant au moins un élément de limitation, laquelle est disposée sur la surface d'enveloppe du cylindre de transfert de distribution ou d'un autre cylindre de transfert,
- utilisation d'une forme d'impression en relief (4) qui est disposée sur la surface d'enveloppe du cylindre de transfert de distribution ou d'un autre cylindre de transfert,
- utilisation d'une surface de réception de moyen d'impression sélective qui est disposée sur la surface d'enveloppe du cylindre de transfert de distribution ou d'un autre cylindre de transfert, dans lequel la surface de réception de moyen d'impression sélective présente au moins une zone de réception avec une adhérence plus élevée pour le moyen d'impression et/ou une surface présentant une meilleure mouillabilité pour le moyen d'impression et au moins une zone de blocage (4') avec une adhérence moindre pour le milieu d'impression par rapport à la zone de réception et/ou une surface présentant une mouillabilité moindre ou ne présentant aucune mouillabilité pour le moyen d'impression de sorte que la longueur des lignes de moyen d'impression (2) soit limitée dans la zone de réception au moyen de la zone de blocage,
- déplacement du cylindre de transfert de distribution par rapport à un ou plusieurs des éléments suivants,
- unité de distribution (1),
- substrat (9),
- un autre cylindre de transfert, en particulier le deuxième cylindre de transfert selon la revendication 12,
de sorte que les lignes de moyen d'impression (2) soient interrompues en raison du déplacement relatif.

14. Procédé selon l'une des revendications 10 à 13,
**caractérisé en ce que**
les lignes de moyen d'impression (2) sont limitées à une longueur qui est inférieure à la longueur du substrat.

15. Procédé selon l'une des revendications 10 à 14,
**caractérisé en ce que**
on utilise un moyen d'impression qui contient des substances dopantes semiconductrices et/ou des particules métalliques,
on utilise un substrat semi-conducteur ou un substrat (9) revêtu d'une couche semi-conductrice en tant que substrat, et
on réalise une structure pour réaliser une structure de mise en contact métallique et/ou une structure de dopage au moyen du procédé pour produire des zones sélectives de dopage dans le substrat semi-conducteur.
